# EUROPÄISCHE PATENTANMELDUNG

(11) **EP 3 147 948 A1**
(43) Veröffentlichungstag der Anmeldung: **29.03.2017**
(21) Anmeldenummer: 16187987.9
(22) Anmeldetag: 09.09.2016
(51) Int. Cl.: H01L 27/32, H01L 51/00

(54) **DREIDIMENSIONALE ORGANISCHE LEUCHTDIODENVORRICHTUNG**

(30) Priorität: 24.09.2015 DE 102015012278
(71) Anmelder: AUDI AG, 85045 Ingolstadt (DE)
(72) Erfinder: Lendle, Reiner, 74855 Haßmersheim (DE); Horn, Michael, 85049 Ingolstadt (DE); Thomas, Werner, 85055 Ingolstadt (DE); Rabenau, Philipp, 85134 Stammham (DE)

(57) **Zusammenfassung**

Die Herstellung und Montage spezifischer organischer Leuchtdiodenvorrichtungen soll vereinfacht werden. Hierzu wird eine organische Leuchtdiodenvorrichtung mit einer organischen Leuchtdiodenschichtanordnung vorgeschlagen, die einen ersten und einen zweiten ebenen Leuchtbereich (5, 6) aufweist. Die Leuchtdiodenschichtanordnung weist außerdem einen ersten Biegebereich (1) auf, in dem die Leuchtdiodenschichtanordnung um eine erste Biegeachse (1a) gebogen ist und der den ersten ebenen Leuchtbereich (5) mit dem zweiten ebenen Leuchtbereich 6) verbindet. Die Leuchtdiodenschichtanordnung weist ferner einen zweiten Biegebereich (2) auf, in dem die Leuchtdiodenschichtanordnung um eine zweite Biegeachse (2a), die zu der ersten Biegeachse (1a) nicht parallel ist, gebogen ist, und der den zweiten ebenen Leuchtbereich (6) mit einem dritten ebenen Leuchtbereich (7) verbindet.

## Beschreibung

Die vorliegende Erfindung betrifft eine organische Leuchtdiodenvorrichtung mit einer organischen Leuchtdiodenschichtanordnung, die einen ersten und zweiten ebenen Leuchtbereich aufweist, wobei die Leuchtdiodenschichtanordnung einen ersten Biegebereich aufweist, in dem die Leuchtdiodenschichtanordnung um eine erste Biegeachse gebogen ist und der den ersten ebenen Leuchtbereich mit dem zweiten ebenen Leuchtbereich verbindet.

Organische Leuchtdioden sind Dünnschichtbauelemente aus organischen, halbleitenden Materialien. Der Vorteil solcher Dünnschichtbauelemente ist, dass sie auf einen Träger aufgebracht werden können und so ohne Weiteres die dreidimensionale Struktur dieses Trägers annehmen können. Darüber hinaus können sie auch auf flexible Träger aufgebracht werden und aufgrund ihres Dünnschichtaufbaus dann mit dem Träger in gewissen Grenzen gebogen werden.

Bislang werden organische Leuchtdioden (OLEDs) für automotive Anwendungen vorwiegend zweidimensional auf Basis eines Glassubstrats gefertigt. Eine entsprechende OLED besitzt dann die zweidimensionale Struktur des Glassubstrats.

Demgegenüber bestehen deutlich mehr räumliche Gestaltungsmöglichkeiten, wenn die organische Leuchtdiode als organische Leuchtdiodenschichtanordnung auf einen flexiblen Träger aufgebracht wird. Beispielsweise handelt es sich bei einem solchen flexiblen Träger um eine biegbare Kunststofffolie. Eine solche Kunststofffolie lässt sich beispielsweise um einen Zylinder wickeln oder auf einen wellenförmigen Untergrund aufbringen. Die Folie ist also in der Regel nur um eine oder mehrere parallele Biegeachsen biegbar. Das Umspannen einer Kugel mit der biegbaren Kunststofffolie ist beispielsweise nicht ohne entsprechende Einschnitte der Folie möglich.

Darüber hinaus werden die Gestaltungs- bzw. Designmöglichkeiten mit flexiblen OLEDs als 2,5D- (gebogener 2d-Körper) bzw. 3D-Designkörper derzeit noch durch die großen zulässigen Biegeradien von mehr als 10 mm stark eingeschränkt. Eine weitere große technologische Herausforderung ergibt sich ferner durch die zusätzliche Belastung der funktionalen Strukturen der OLED durch die Biegung, was eine Verkürzung der OLED-Lebensdauer zur Folge hat. Eine Formgebung durch Torsion stellt hierbei die größte mechanische Belastung für das Bauteil dar, was eine Umsetzung in der Fahrzeugbeleuchtung derzeit noch ausschließt.

Nachteilig an der Verwendung von festen Glassubstraten als Träger ist, dass solche 2D-Glassubstrate eine räumliche Gestaltung der Lichtquelle unmöglich machen. Auch der Einsatz flexibler OLEDs als 2,5D-Element mit Biegeradien von mehr als 10 mm schränkt, wie erwähnt, die Designfreiheit ein. Da zudem eine Torsion der OLED nicht möglich ist, werden viele einzelne OLED-Bauteile benötigt, um anspruchsvolle 3D-Designs zu realisieren. Die Komplexität in der Gestaltung erfordert einen hohen technischen Aufwand durch den Einsatz vieler verschiedener einzelner OLEDs im Herstellungs- und Montageprozess.

Die Aufgabe der vorliegenden Erfindung besteht somit darin, eine organische Leuchtdiodenvorrichtung bereitzustellen, mit der räumliche Leuchtkörper leichter realisierbar sind.

Erfindungsgemäß wird diese Aufgabe gelöst durch eine organische Leuchtdiodenvorrichtung mit
- einer organischen Leuchtdiodenschichtanordnung, die einen ersten und zweiten Leuchtbereich aufweist, wobei
- die Leuchtdiodenschichtanordnung einen ersten Biegebereich aufweist, in dem die Leuchtdiodenschichtanordnung um eine erste Biegeachse gebogen ist und der den ersten Leuchtbereich mit dem zweiten Leuchtbereich verbindet,
wobei
- die Leuchtdiodenschichtanordnung einen zweiten Biegebereich aufweist, in dem die Leuchtdiodenschichtanordnung um eine zweite Biegeachse, die zu der ersten Biegeachse nicht parallel ist, gebogen ist und der den zweiten Leuchtbereich mit einem dritten Leuchtbereich verbindet.

Optional berührt sich jede Grenzlinie gebildet zwischen jeweils einem Paar von einem der Biegebereiche und einem der Leuchtbereiche allenfalls in einem einzigen Punkt mit einer der anderen Grenzlinien. Dadurch werden in der Leuchtdiodenschichtanordnung Bereiche vermieden, die in mehrere Richtungen gebogen sind.

Die organische Leuchtdiodenvorrichtung besitzt also fünf voneinander getrennte Bereiche, die aneinander angrenzen. Alle Bereiche werden durch die einteilige bzw. zusammenhängende organische Leuchtdiodenschichtanordnung gebildet. Es handelt sich also um ein einziges Bauteil, so dass die Herstellung und die Montage entsprechend vereinfacht ist.

Bei den fünf Bereichen handelt es sich um drei Leuchtbereiche und zwei Biegebereiche. Jeweils zwei der Leuchtbereiche sind über einen Biegebereich miteinander verbunden. Während die Leuchtbereiche z.B. im Wesentlichen eben sind, besitzen die Biegebereiche eine Biegeachse, um die die jeweilige Biegung erfolgt. Das zweidimensionale Gebilde der Leuchtdiodenschichtanordnung erstreckt sich in einem Biegebereich also auf einem Abschnitt eines Zylindermantels, wobei die Zylinderachse der Biegeachse entspricht. Der Radius des Zylinders entspricht z.B. dem Biegeradius. Der Biegeradius muss aber nicht konstant sein. Beispielsweise kann sich der Biegeradius in dem Biegebereich spiralförmig ändern.

Die erfindungsgemäße organische Leuchtdiodenvorrichtung besitzt also zwei Biegebereiche mit zwei verschiedenen Biegeachsen. Diese Biegeachsen verlaufen nicht parallel zueinander, d.h. ihre senkrechten Projektionen auf die ungebogene Leuchtdiodenschichtanordnung schneiden sich in einem Punkt. Durch die nicht parallelen Biegeachsen können Körper realisiert werden, die von der reinen Wellenform abweichen. Der Schnittpunkt der beiden Projektionen liegt außerhalb der ungebogenen Leuchtdiodenschichtanordnung. Dadurch werden in der Leuchtdiodenschichtanordnung Bereiche vermieden, die in mehrere Richtungen gebogen sind.

Die organische Leuchtdiodenvorrichtung ist natürlich nicht darauf beschränkt, dass sie nur drei Leuchtbereiche und zwei Biegebereiche aufweist. Vielmehr kann sie auch weitere Biege- und Leuchtbereiche besitzen. So können beispielsweise Biege- und Leuchtbereiche abwechselnd zu einer beliebig langen Kette hintereinander angeordnet werden.

Die Biegeachsen nehmen einen von 0 verschiedenen Winkel zueinander ein. Ein entsprechender spitzer Winkel α kann vorzugsweise im Bereich von 0° < α ≤ 90° liegen, aber auch größere Winkelabweichungen sind realisierbar.

Ein Leuchtbereich kann homogen als gesamte Leuchteinheit angesteuert werden. Darüber hinaus kann ein Leuchtbereich aber auch in Unterleuchtbereiche unterteilt sein. Jeder dieser Unterleuchtbereiche kann mit einer separaten Stromstärke bzw. Helligkeit angesteuert werden. Gegebenenfalls besitzen die Unterleuchtbereiche auch verschieden Farben.

Vorzugsweise berührt der erste Biegebereich den zweiten Biegebereich nicht oder nur in einem einzigen Punkt. Dies bedeutet, dass in jedem Biegebereich eine zylindermantelkonforme Biegung ohne Torsion möglich ist. Dies erhöht die Lebensdauer der organischen Leuchtdiodenvorrichtung.

Jeder der Leuchtbereiche besitzt in einer Ausführungsform einen größeren Biegeradius als jeder der Biegebereiche. Dies bedeutet, dass die Leuchtbereiche eben oder leicht gebogen sein können.

Die Leuchtdiodenschichtanordnung kann über alle Leuchtbereiche und Biegebereiche einteilig gebildet sein. Dies bedeutet, dass prinzipiell nicht nur die Leuchtbereiche, sondern auch die Biegebereiche zum Leuchten angesteuert werden können. Im einfachsten Fall besitzt die organische Leuchtdiodenvorrichtung damit eine einheitliche Oberfläche und ist somit einfach herzustellen. Vorzugsweise ist die Leuchtdiodenschichtanordnung auf einer biegbaren Trägerschicht aufgetragen. Bei einer solchen biegbaren Trägerschicht kann es sich um eine Kunststofffolie handeln. Diese wiederum kann auf etwaige Gebilde oder Halter beispielsweise eines Kraftfahrzeugs in dreidimensionaler Form aufgebracht werden. Vorteilhafterweise ist die gesamte Trägerschicht mit der Leuchtdiodenschichtanordnung beschichtet.

In einer bevorzugten Ausgestaltung ist eine erste Grenzlinie zwischen dem ersten Leuchtbereich und dem ersten Biegebereich parallel zur ersten Biegeachse, eine zweite Grenzlinie zwischen dem zweiten Leuchtbereich und dem ersten Biegebereich parallel zur ersten Biegeachse, eine dritte Grenzlinie zwischen dem zweiten Leuchtbereich und dem zweiten Biegebereich parallel zur zweiten Biegeachse und eine vierte Grenzlinie zwischen dem zweiten Biegebereich und dem dritten Leuchtbereich parallel zur zweiten Biegeachse. Dies hat den Vorteil, dass die Biegebereiche Abschnitte von Zylindermänteln sind. Entsprechend einer alternativen Ausführungsform können die jeweiligen Grenzlinien auch einen Winkel zu der korrespondierenden Biegeachse aufweisen, so dass der angrenzende Leuchtbereich gegenüber der Biegeachse entsprechend gedreht ist.

Zumindest zwei der Leuchtbereiche können voneinander unabhängig von einer Ansteuereinrichtung angesteuert sein. Es müssen also nicht sämtliche Leuchtbereiche der organischen Leuchtdiodenvorrichtung einheitlich angesteuert werden, sondern sie können vielmehr einzeln oder in Gruppen angesteuert werden. Dadurch erhöht sich der Einsatzbereich der organischen Leuchtdiodenvorrichtung.

Prinzipiell können zumindest zwei der Leuchtbereiche auch in Serie oder parallel von der Ansteuereinrichtung angesteuert sein. Dies bedeutet, dass diese beiden Leuchtbereiche dann miteinander und gegebenenfalls auch gleich hell leuchten, wenn sie zusammen angesteuert werden. Diese zusammen geschalteten Leuchtbereiche müssen nicht aneinandergrenzen, sondern vielmehr kann zwischen den Leuchtbereichen neben dem Biegebereich auch ein weiterer Leuchtbereich angeordnet sein.

In einer speziellen Ausführungsform ist mindestens einer der Biegebereiche auch zum Leuchten anregbar. Hierdurch erhalten die Biegebereiche die zusätzliche Funktionalität des Leuchtens neben ihrer Grundfunktionalität des Gebogenseins. Damit kann die Leuchteffizienz der Leuchtdiodenvorrichtung gegenüber dem Fall gesteigert sein, dass ausschließlich die Leuchtbereiche zum Leuchten anregbar sind. Es könnte auch eine einzige Leuchtfläche realisiert sein, die in mehrere Richtungen gebogen ist. Die Kombination mit den nichtleuchtenden Bereichen ist nicht zwingend. Nichtleuchtende Bereiche bieten sich an, um kleinere Biegeradien zu erreichen.

Weiterhin können mindestens zwei der Leuchtbereiche voneinander unterschiedliche Leuchtfarben besitzen. So kann beispielsweise ein erster Leuchtbereich zum Leuchten in roter Farbe und ein zweiter Leuchtbereich zum Leuchten in gelber oder grüner Farbe angeregt bzw. angesteuert werden. Auch können beispielsweise Biegebereiche in anderen Farben leuchten als Leuchtbereiche. Gegebenenfalls können auch die einzelnen Leuchtbereiche zu unterschiedlichen Helligkeiten angeregt werden, so dass beispielsweise ein erster Bereich heller leuchtet als ein zweiter Bereich.

Bei einer besonders bevorzugten Anwendung wird ein Kraftfahrzeug mit einer derartigen organischen Leuchtdiodenvorrichtung, wie sie oben beschrieben ist, ausgestattet. Hierbei kann beispielsweise ein Schlusslicht, ein Bremslicht und/oder ein Blinklicht mit dieser organischen Leuchtdiodenvorrichtung realisiert sein. Auf diese Weise kann beispielsweise die Rückleuchte eines Kraftfahrzeugs, welche die genannten Lichter aufweist, mit einer einzigen Leuchtdiodenvorrichtung ausgeführt sein. Durch die dreidimensionale Gestaltung können dann nicht nur die gesetzlichen Vorgaben, was Helligkeit und Winkelverteilung betrifft, eingehalten werden, sondern es werden auch besondere Designmöglichkeiten eröffnet.

Die vorliegende Erfindung wird nun anhand der beigefügten Zeichnungen näher erläutert, in denen zeigen:
- Fig. 1: eine Draufsicht auf eine ungebogene organische Leuchtdiodenvorrichtung mit mehreren Leucht- und Biegebereichen;
- Fig. 2: die organische Leuchtdiodenvorrichtung von Fig. 1 mit eingezeichneten Leuchtbereichen; und
- Fig. 3: ein Kraftfahrzeug, bei dem beispielsweise eine Rückleuchte mit einer erfindungsgemäßen organischen Leuchtdiodenvorrichtung ausgestattet ist.

Die nachfolgend näher geschilderten Ausführungsbeispiele stellen bevorzugte Ausführungsformen der vorliegenden Erfindung dar. Dabei ist zu beachten, dass die einzelnen Merkmale nicht nur in den geschilderten Merkmalskombinationen, sondern auch in Alleinstellung oder in anderen Kombinationen realisierbar sind.

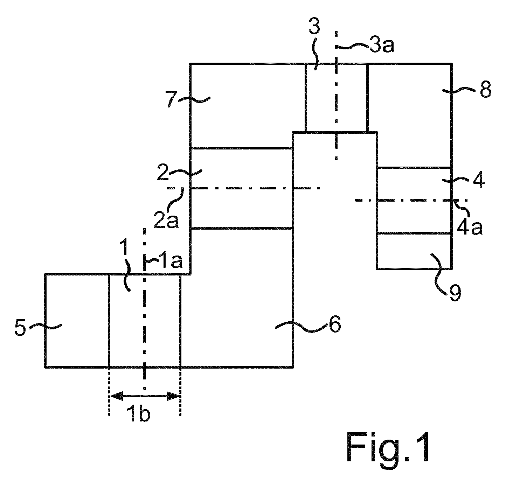

In dem Beispiel von Fig. 1 ist eine organische Leuchtdiodenvorrichtung mit einer spezifischen Kontur in einer Draufsicht dargestellt. Die organische Leuchtdiodenvorrichtung besitzt über der gesamten Fläche den gleichen prinzipiellen Schichtaufbau. Bei anderen Ausführungsbeispielen kann der Schichtaufbau lokal durchaus unterschiedlich sein.

Als Träger wird eine biegbare Trägerschicht verwendet, die beispielsweise eine transparente Kunststofffolie sein kann. Die biegbare Trägerschicht ist mit einer organischen Leuchtdiodenschichtanordnung beschichtet. Eine solche organische Leuchtdiodenschichtanordnung weist typischerweise mehrere Schichten auf, von denen eine eine Kathode und eine andere eine Anode darstellt. Zwischen der Anodenschicht und der Kathodenschicht befinden sich beispielsweise Ladungsträgerinjektions- und Transportschichten sowie eine Emitterschicht. Eine solche Schichtanordnung ist beispielsweise wenige Zehntel Millimeter dick. Sie beeinträchtigt daher die Biegbarkeit der Trägerschicht in der Regel nur geringfügig. In dem Bild von Fig. 1 ist die organische Leuchtdiodenschichtanordnung von oben dargestellt, weshalb die einzelnen Schichten nicht zu erkennen sind. Darüber hinaus ist auch die darunter liegende, deckungsgleiche, biegbare Trägerschicht nicht zu erkennen.

Die spezielle Form der in Fig. 1 abgewickelten bzw. noch nicht gebogenen 2D-Leuchtdiodenvorrichtung ergibt sich aus dem 3D-Körper, der nach dem Biegen erhalten werden soll. Mit dem 2D-Gebilde von Fig. 1 kann beispielsweise nach dem Biegen eine Art Viertelkugel erhalten werden. Eine so geformte Leuchtvorrichtung kann beispielsweise in vier von sechs Raumrichtungen Licht abstrahlen.

Konkret besitzt die organische Leuchtdiodenvorrichtung von Fig. 1 einen ersten Biegebereich 1, einen zweiten Biegebereich 2, einen dritten Biegebereich 3 und einen vierten Biegebereich 4. Der erste Biegebereich 1 liegt zwischen einem ersten Leuchtbereich 5 und einem zweiten Leuchtbereich 6. Der zweite Biegebereich 2 liegt zwischen dem zweiten Leuchtbereich 6 und einem dritten Leuchtbereich 7. Der dritte Biegebereich 3 liegt zwischen dem dritten Leuchtbereich 7 und einem vierten Leuchtbereich 8. Der vierte Biegebereich 4 schließlich liegt zwischen dem vierten Leuchtbereich 8 und einem fünften Leuchtbereich 9. Die Anzahl der Leuchtbereiche beträgt mindestens drei und ist nach oben nicht begrenzt. Die Anzahl der Biegebereiche beträgt mindestens zwei und ist ebenfalls nach oben nicht begrenzt.

Im vorliegenden Beispiel sind die Biegebereiche 1 bis 4 rechteckförmig ausgestaltet. An gegenüberliegenden Seiten schließt jeweils ein Leuchtbereich an. Jeder Biegebereich zeichnet sich dadurch aus, dass er im endgültigen Zustand gebogen ist, während jeder Leuchtbereich weniger gebogen oder eben ist. Den Übergang zwischen einem Biegebereich und einem Leuchtbereich bildet eine jeweilige Grenzlinie. Alternativ können die Biegebereiche auch dreiecksförmig oder trapezförmig ausgebildet sein.

Jeder Biegebereich 1 bis 4 besitzt hier eine jeweilige Biegeachse 1a, 2a, 3a und 4a. Diese jeweilige Biegeachse liegt nicht in der Ebene der abgewickelten Leuchtdiodenvorrichtung, sondern darüber oder darunter, je nachdem, in welche Richtung gebogen wird. Der Abstand der jeweiligen Biegeachse zur Ebene der Leuchtdiodenvorrichtung wird durch den jeweiligen Biegeradius bestimmt. Die Breite 1 b beispielsweise des ersten Biegebereichs 1 kann wie derjenige der anderen Biegebereiche bedarfsmäßig gewählt werden.

Im Fall von Fig. 1 besitzt die zweidimensionale, abgewinkelte Leuchtdiodenvorrichtung die Gestalt von zwei aneinandergefügten "L". Das erste "L" bilden die Bereiche 5, 1, 6, 2 und 7, während das zweite "L" die Bereiche (7), 3, 8, 4 und 9 bilden. Dies bedeutet, dass die Leuchtbereiche 5, 6, 7, 8 und 9 hier ebenfalls rechteckförmig ausgestaltet sind, sie können aber auch eine andere Form besitzen. Die Biegeachsen der Biegebereiche verlaufen jeweils senkrecht zu den jeweiligen Schenkeln der beiden "L". Jeder Biegebereich 1, 2, 3, 4 besitzt zwei gegenüberliegende Seiten, die die Grenze zu jeweils benachbarten Leuchtbereichen bilden. Die Grenzlinien eines Biegebereichs zu den benachbarten Leuchtbereichen müssen nicht parallel sein und können aufeinander zulaufen, wenn der Biegebereich beispielsweise dreiecksförmig oder trapezförmig gebildet ist. Ein Biegebereich kann aber auch beispielsweise die Form eine Parallelogramms annehmen. Der Biegeradius innerhalb einer Beigefläche muss im Verlauf nicht konstant sein, sondern kann variieren. Beispielsweise kann ein weicher Anlauf und Auslauf vorgesehen sein, dazwischen ein kleinerer Biegeradius.

Die Grenzlinien zwischen Biegebereichen und Leuchtbereichen verlaufen hier parallel zu der jeweiligen Achse des Biegebereichs. Auch dies ist nur optional. Die Biegebereiche 1 bis 4 berühren sich im vorliegenden Beispiel nicht. Auf diese Weise lassen sich beispielsweise Torsionen der Biege- und Leuchtbereiche vermeiden. So bleibt beispielsweise der Leuchtbereich 8 vollkommen eben, auch wenn der dritte Biegebereich 3 um die Biegeachse 3a und der vierte Biegebereich 4 um die Biegeachse 4a gebogen wird. Insgesamt ergibt sich durch die Form der OLED und die Lage der Biegebereiche ein 3D-Körper, obwohl die OLED in jedem Biegebereich nur entlang einer Achse gebogen wird.

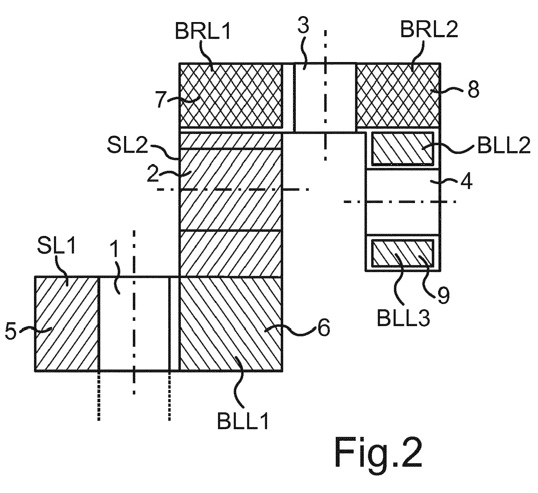

Fig. 2 zeigt die Struktur der organischen Leuchtdiodenvorrichtung von Fig. 1 mit einer konkreten Zuweisung der Leuchtfunktionalität zu den einzelnen Bereichen der organischen Leuchtdiodenvorrichtung.

Der erste Leuchtbereich 5 besitzt hierbei beispielsweise die Funktionalität SL1, nämlich die eines ersten Schlusslichts. Ein Teil des zweiten Leuchtbereichs 6 besitzt die Funktionalität BLL1, nämlich die eines ersten Blinklichts. Ein anderer Teil des zweiten Leuchtbereichs 6 besitzt die Funktionalität SL2, nämlich die eines Teils eines zweiten Schlusslichts. Der zweite Biegebereich und ein Teil des dritten Leuchtbereichs 7 besitzen ebenfalls die Funktionalität SL2. Dies bedeutet nicht nur, dass ein Biegebereich grundsätzlich auch die Leuchtfunktionalität wie ein Leuchtbereich übernehmen kann, sondern dass auch die Leuchtfunktionalität nicht an die physischen Grenzen der einzelnen Leucht- und Biegebereiche gekoppelt sein muss.

Außer der Funktionalität SL2 übernimmt der dritte Leuchtbereich 7 auch die Funktionalität BRL1 eines ersten Bremslichts. Der vierte Leuchtbereich 8 übernimmt die Funktionalitäten BRL2 und BLL2 für ein zweites Bremslicht und ein zweites Blinklicht. Der fünfte Leuchtbereich 9 besitzt die Funktionalität BLL3 eines dritten Blinklichts.

Die einzelnen Bereiche der organischen Leuchtdiodenvorrichtung werden durch eine in Fig. 2 nicht dargestellte Ansteuervorrichtung angesteuert. In einer bevorzugten Ausgestaltung lassen sich die einzelnen funktionalen Bereiche unabhängig von den physischen Bereichen 1 bis 9 ansteuern bzw. adressieren.

Das Ausführungsbeispiel von Fig. 2 zeigt ferner, dass eine organische Leuchtdiodenvorrichtung als einzelnes Bauelement durchaus unterschiedliche Emitterschichten aufweisen kann, so dass unterschiedliche Leuchtfarben in verschiedenen funktionellen Bereichen realisiert werden können. Gegebenenfalls kann auch die Option bestehen, die verschiedenen Bereiche mit unterschiedlichen Stromstärken anzusteuern, so dass die Helligkeit entsprechend variiert werden kann.

Bei einer weiteren Ausführungsvariante der Leuchtdiodenschichtanordnung liegen verschiedene Leuchtschichten übereinander, die gleich oder unterschiedlich angesteuert werden, womit sich verschiedene Farben auf der gleichen Fläche darstellen lassen. Eine weitere Ausführungsform besteht darin, dass die Leuchtbereiche beispielsweise in Streifenform oder in sehr kleinen Pixeln nebeneinander liegen. Damit lassen sich unterschiedliche Effekte wie Mehrfarbigkeit, Muster oder gar Displays darstellen. Weitere Variationen sind denkbar.

Es ist ferner in dem Beispiel von Fig. 2 zu erkennen, dass nicht jeder Biegebereich Leuchtfunktionalität besitzen muss. So kann beispielsweise vorgesehen sein, dass nur ein solcher Biegebereich für die Leuchtfunktionalität verwendet wird, der einen Biegeradius mit einem bestimmten Mindestmaß besitzt.

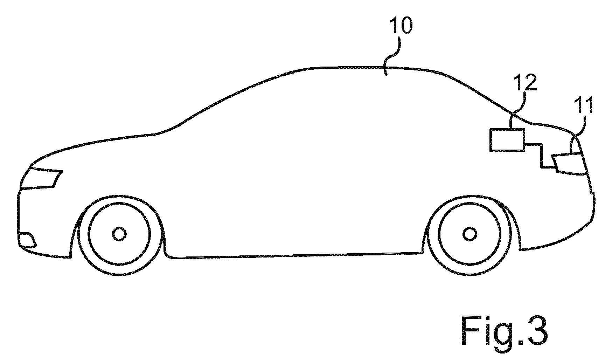

Fig. 3 gibt schematisch ein Kraftfahrzeug 10 wieder, dessen Rückleuchte 11 mit einer oben dargestellten organischen Leuchtdiodenvorrichtung ausgestattet ist. Eine solche Rückleuchte 11 besitzt typischerweise ein Schlusslicht, ein Bremslicht und ein Blinklicht. Nach gesetzlichen Vorgaben müssen die einzelnen Lichter nicht nur eine gewisse Helligkeit, sondern auch eine bestimmte Winkelverteilung besitzen. Dies lässt sich hier einfach durch eine einzige organische Leuchtdiodenvorrichtung realisieren. Zur Erzielung einer gewissen Helligkeit wird eine geeignete Fläche der Leuchtdiodenvorrichtung mit einem entsprechenden Strom angesteuert. Die Winkelverteilung lässt sich durch entsprechendes Biegen von Abschnitten der Leuchtdiodenvorrichtung erreichen, wobei gegebenenfalls mehrere Leuchtbereiche in unterschiedliche Richtungen weisen, um z. B. eine gemeinsame Schlusslichtfunktionalität (SL1 und SL2) zu erreichen. Die entsprechende Ansteuereinrichtung 12 ist in das Kraftfahrzeug 10 integriert.

Die vorliegende Erfindung sieht somit die Umsetzung eines 3D-OLED-Moduls aus einer einzelnen OLED vor, die aus mehreren Biegelinien auf dem Bauteil sowie die individuellen Bauteilmaße und -formen entsteht. Die daraus hervorgehenden einzelnen Teilflächen können zudem durch gezielte Segmentierung der OLED unabhängig voneinander angesteuert werden und somit verschiedene Lichtfunktionen realisieren. An einem Beispiel wurde gezeigt, dass in der Heckbeleuchtung eine Teilfläche die Schlusslichtfunktion erfüllt, während eine weitere Teilfläche das Bremslicht darstellt. Alternativ können die Flächen in Doppelfunktion sowohl als Schlusslicht als auch als Bremslicht etc. fungieren. Es ergeben sich hierbei beliebige Kombinationsmöglichkeiten in der Schaltung der einzelnen Teilflächen und ihrem Zusammenspiel. Hiermit ergeben sich völlig neue Design- und Gestaltungsmöglichkeiten im Leuchtenbau.

## Patentansprüche

1. Organische Leuchtdiodenvorrichtung mit
- einer organischen Leuchtdiodenschichtanordnung, die einen ersten und zweiten Leuchtbereich (5, 6) aufweist, wobei
- die Leuchtdiodenschichtanordnung einen ersten Biegebereich (1) aufweist, in dem die Leuchtdiodenschichtanordnung um eine erste Biegeachse (1a) gebogen ist und der den ersten Leuchtbereich (5) mit dem zweiten Leuchtbereich (6) verbindet,
**dadurch gekennzeichnet, dass**
- die Leuchtdiodenschichtanordnung einen zweiten Biegebereich (2) aufweist, in dem die Leuchtdiodenschichtanordnung um eine zweite Biegeachse (2a), die zu der ersten Biegeachse (1a) nicht parallel ist, gebogen ist und der den zweiten Leuchtbereich (6) mit einem dritten Leuchtbereich (7) verbindet.

2. Organische Leuchtdiodenvorrichtung nach Anspruch 1, wobei sich jede Grenzlinie gebildet zwischen jeweils einem Paar von einem der Biegebereiche und einem der Leuchtbereiche allenfalls in einem Punkt mit einer der anderen Grenzlinien berührt.

3. Organische Leuchtdiodenvorrichtung nach Anspruch 1 oder 2, wobei der erste Leuchtbereich (5) und der zweite ebene Leuchtbereich (6) einander nicht berühren oder sich nur in einem einzigen Punkt berühren.

4. Organische Leuchtdiodenvorrichtung nach einem der vorhergehenden Ansprüche, wobei jeder der Leuchtbereiche einen größeren Biegeradius besitzt als jeder der Biegebereiche.

5. Organische Leuchtdiodenvorrichtung nach einem der vorhergehenden Ansprüche, wobei sich in mindestes einem der Biegebereiche ein Biegeradius entlang der jeweiligen Biegeachse oder in dem Biegebereich spiralförmig verändert.

6. Organische Leuchtdiodenvorrichtung nach einem der vorhergehenden Ansprüche, wobei die Leuchtdiodenschichtanordnung über alle Leuchtbereiche (5 bis 9) und Biegebereiche (1 bis 4) einteilig gebildet ist.

7. Organische Leuchtdiodenvorrichtung nach einem der vorhergehenden Ansprüche, wobei die Leuchtdiodenschichtanordnung auf einer biegbaren Trägerschicht aufgetragen ist.

8. Organische Leuchtdiodenvorrichtung nach einem der vorhergehenden Ansprüche, wobei eine erste Grenzlinie zwischen dem ersten Leuchtbereich (5) und dem ersten Biegebereich (1) parallel zur ersten Biegeachse (1a), eine zweite Grenzlinie zwischen dem zweiten Leuchtbereich (6) und dem ersten Biegebereich (1) parallel zur ersten Biegeachse (1a), eine dritte Grenzlinie zwischen dem zweiten Leuchtbereich (6) und dem zweiten Biegebereich (2) parallel zur zweiten Biegeachse (2a) und eine vierte Grenzlinie zwischen dem zweiten Biege (2) bereich und dem dritten ebenen Leuchtbereich (7) parallel zur zweiten Biegeachse (2a) verlaufen.

9. Organische Leuchtdiodenvorrichtung nach einem der vorhergehenden Ansprüche, wobei zumindest zwei der Leuchtbereiche voneinander unabhängig von einer Ansteuereinrichtung (12) angesteuert sind.

10. Organische Leuchtdiodenvorrichtung nach einem der Ansprüche 1 bis 8, wobei zumindest zwei der Leuchtbereiche in Serie oder parallel von einer Ansteuereinrichtung (12) angesteuert sind.

11. Organische Leuchtdiodenvorrichtung nach einem der vorhergehenden Ansprüche, wobei mindestens einer der Biegebereiche auch zum Leuchten anregbar ist.

12. Organische Leuchtdiodenvorrichtung nach einem der vorhergehenden Ansprüche, wobei mindestens zwei der Leuchtbereiche voneinander unterschiedliche Leuchtfarben besitzen.

13. Kraftfahrzeug (10), bei dem ein Schlusslicht, und/oder ein Bremslicht und/oder ein Blinklicht mit einer organischen Leuchtdiodenvorrichtung nach einem der vorhergehenden Ansprüche realisiert ist.
